# EUROPEAN PATENT APPLICATION

(11) **EP 1 211 701 A1**
(43) Date of publication of application: **05.06.2002**
(21) Application number: 01128731.5
(22) Date of filing: 03.12.2001
(51) Int. Cl.: H01F 27/28, H01F 41/04, H01F 41/10

(54) **Planar inductor with a ferromagnetic core, and fabrication method therefor**

(30) Priority: 04.12.2000 IT TO001128
(71) Applicant: C.R.F. Società Consortile per Azioni, 10043 Orbassano (Torino) (IT)
(72) Inventor: Catona, Giuseppe, 10147 Torino (IT)
(74) Representative: Franzolin, Luigi

(57) **Abstract**

There is described a planar inductor (30) formed on a printed circuit board (2) having a substrate (4) of electrically insulating material. The planar inductor (30) has a first and a second planar winding (10, 32) located on opposite faces of the substrate (4), and each having an outer end (12, 34) and an inner end (14, 36); and a planar core (16) carried by the printed circuit board (2) and connected to the first and second planar winding (10, 32). A metalized through hole (38) is formed through the substrate (4) to electrically connect the inner ends (14) of the first and second planar winding (10, 32) to form a continuous planar winding, the outer ends (12, 34) of which define the terminals of the planar inductor (30).

## Description

The present invention relates to a planar inductor with a ferromagnetic core, and relative fabrication method.

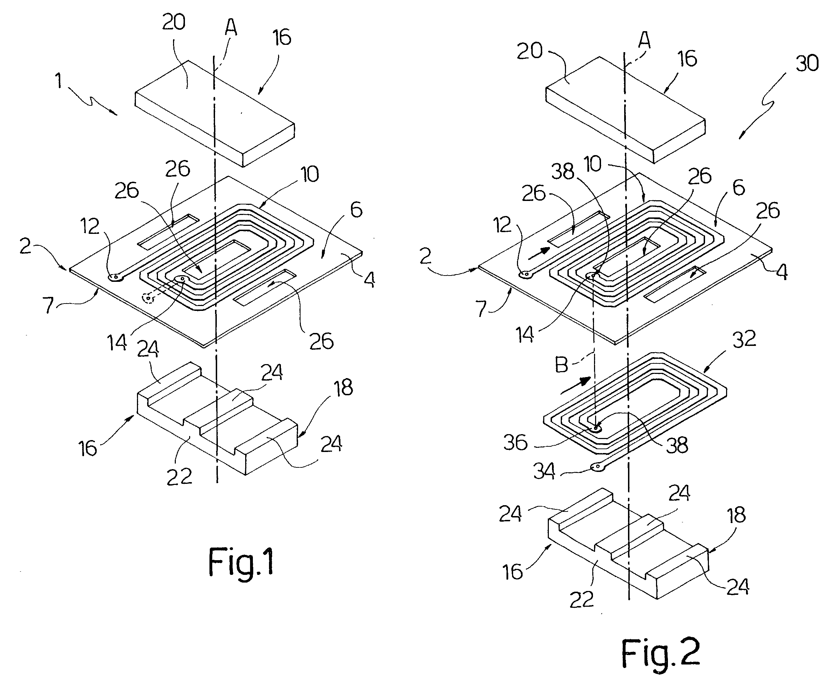

Fabricating planar inductors with a ferromagnetic core on printed circuit boards is a known, widely used technique, as shown schematically in Figure 1.

More specifically, Figure 1 shows the fabrication of a planar inductor 1 on a single-layer (or so-called double-sided) printed circuit board 2, i.e. of the type comprising a single substrate 4 of electrically insulating material, typically an organic material known as FR4.

As shown in Figure 1, planar inductor 1 is fabricated by forming, on one face 6 of substrate 4, a continuous spiral planar winding 10, the inner and outer ends 14, 12 of which define the two terminals of planar inductor 1.

Substrate 4 is then fitted with a planar core 16 made of ferromagnetic material, typically ferrite, and defined by a first E-shaped member 18 and a second platelike member 20, which are sandwiched on to substrate 4 at planar winding 10.

More specifically, first member 18 of planar core 16 is fitted to one face of substrate 4 - in the example shown, face 7, on the opposite side to the face on which planar winding 10 is formed - and comprises a rectangular, platelike base portion 22; and three parallelepiped-shaped projecting portions 24 - one central and two lateral - projecting from base portion 22 and inserted through respective through openings 26 - a central through opening inside planar winding 10, and two lateral through openings on diametrically opposite sides of planar winding 10 - formed in substrate 4. The second member 20 of planar core 16 is mounted on the opposite face of substrate 4, and contacting projecting portions 24 of first member 18.

Using known techniques not described in detail, planar winding 10 can be formed either by chemically etching a layer of electrically conducting material, typically copper, deposited beforehand on the face of substrate 4, or by depositing electrically conducting material, typically ink, on the face of substrate 4.

Once planar core 16 is mounted, the outer end 12 of planar winding 10 is connected by a track (not shown) to an electric circuit in which planar inductor 1 is used; and the inner end 14 of planar winding 10 is connected electrically to the electric circuit by a track (shown by the dash line in Figure 1) formed on face 7 of substrate 4 opposite the face on which planar winding 10 is formed, and connected to inner end 14 of planar winding 10 through a metalized through hole.

Though widely used, planar inductors with a ferromagnetic core of the type described above have a major drawback preventing them from being exploited to full advantage.

The main limitation intrinsic in this type of planar inductor is the poor use made of the space available to the winding on the printed circuit board. That is, the space occupied by the winding includes not only the area actually occupied by the turns, but also the area necessarily occupied by the insulation between adjacent turns.

The need for a planar inductor capable of handling high power values therefore often conflicts with the need for smaller printed circuits, or with the normally limited amount of space available for such components on the printed circuit board.

It is an object of the present invention to provide a planar inductor with a ferromagnetic core, and relative fabrication method, designed to eliminate the aforementioned drawbacks.

According to the present invention, there is provided a planar inductor, as claimed in Claim 1.

According to the present invention, there is also provided a method of fabricating a planar inductor, as claimed in Claim 13.

A number of preferred, non-limiting embodiments of the present invention will be described by way of example with reference to the accompanying drawings, in which:
Figure 1 shows an exploded view in perspective of a printed circuit comprising a planar inductor with a ferromagnetic core formed using the known method;
Figure 2 shows an exploded view in perspective of a printed circuit comprising a planar inductor with a ferromagnetic core in accordance with a first embodiment of the present invention;
Figure 3 shows an exploded view in perspective of a printed circuit comprising a planar inductor with a ferromagnetic core in accordance with a second embodiment of the present invention;
Figure 4 shows an exploded view in perspective of a printed circuit comprising a planar inductor with a ferromagnetic core in accordance with a third embodiment of the present invention.

Number 30 in Figure 2 indicates as a whole a planar inductor formed in accordance with the present invention, and any parts of which similar to those in Figure 1 are indicated using the same reference numbers.

In particular, planar inductor 30 differs from planar inductor 1 by also comprising a second continuous spiral planar winding 32 formed on the face of substrate 4 opposite the face on which the first planar winding 10 is formed, and having an outer end 34 and an inner end 36.

More specifically, first and second planar windings 10, 32 are coaxial with an axis A perpendicular to printed circuit board 2, and are formed so that inner ends 14, 36 are aligned along an axis B parallel to axis A.

A metalized through hole 38, coaxial with axis B and formed in substrate 4, electrically connects inner ends 14, 36 of first and second planar windings 10, 32, so as to connect the windings in series and so form a single continuous winding, the outer ends 12, 34 of which define the two terminals of planar inductor 30.

Viewed from the same side of substrate 4, first and second windings 10, 32 are coiled in the same direction - clockwise in Figure 2 - so that the current in both windings 10, 32 flows in the same direction indicated by the arrows in Figure 2.

More specifically, first winding 10 is coiled inwardly clockwise, while second winding 32, viewed from the same side of substrate 4, is also coiled clockwise but outwards.

A planar inductor formed in accordance with the present invention has numerous advantages over those formed using the known technique.

More specifically, forming a planar inductor by series connecting two separate windings formed on opposite faces of substrate 4 of printed circuit 2, the area occupied by the planar inductor is divided between the two faces, so that, for a given total area occupied on one face, the present invention provides for obtaining a planar inductor capable of handling much higher power values than those of the known art.

Conversely, according to the present invention, for given magnetic and electric characteristics of the planar inductor, the printed circuit board area occupied by it is greatly reduced with respect to that of known planar inductors, by reducing not only the area occupied by the turns of the winding, but also the area required to insulate the turns.

The principle described above in connection with a planar inductor formed on a single-layer printed circuit board 2 may also be applied to advantage in modular manner, as described below, to multilayer printed circuit boards, i.e. comprising a number of substrates of electrically insulating material, to form planar inductors with particular characteristics.

For example, since the maximum current flow in a planar inductor is proportional to the area of each of its turns, the principle underlying the present invention provides for forming, on a multilayer printed circuit board, a planar inductor comprising more than two windings, the total turn area of which provides, for a given amount of heat produced by power dissipation, for greatly increasing the current flow in the planar inductor as compared with known types, or, conversely, for a given current flow in the planar inductor, for greatly reducing the heat produced by power dissipation as compared with known planar inductors.

More specifically, such a planar inductor can be formed using two or more pairs of first and second planar windings of the type described above, wherein the first and second planar winding in each pair are series connected as described below, and the various pairs of planar windings are connected in parallel.

To be connected as described, the planar windings must be so formed that the inner ends are all coaxial and connectable electrically by means of a first metalized through hole; the first planar windings must be so formed that the outer ends are all coaxial and connectable electrically by means of a second metalized through hole; and the second planar windings must be so formed that the outer ends are all coaxial and connectable electrically by means of a third metalized through hole.

The first planar windings are therefore connected in parallel; the second planar windings are connected in parallel; and the two groups of planar windings are connected in series.

The resulting planar inductor will therefore have an inductance value which can be calculated using known equations, and will have a total area equal to the sum of the areas of the individual planar windings.

Given the equivalent inductance value and required maximum current flow of the desired planar inductor, the inductance value and the area of each planar winding need therefore simply be designed accordingly.

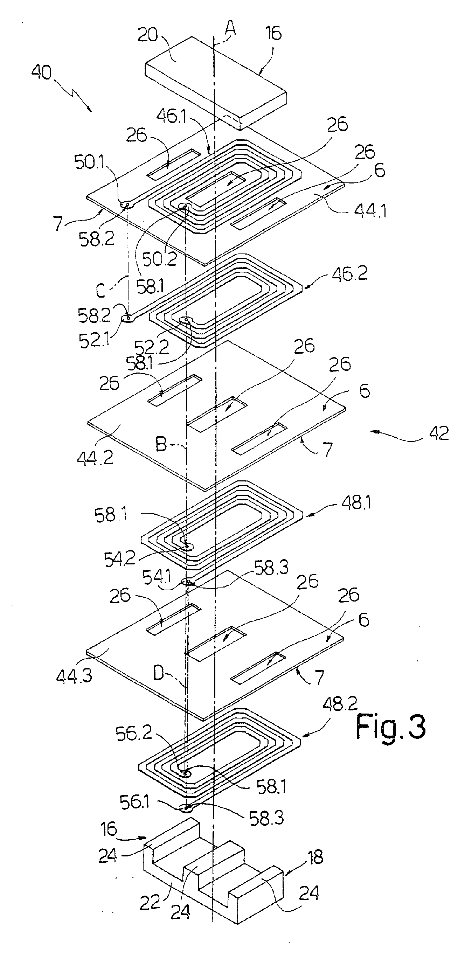

Figure 3 shows a planar inductor of the above type formed on a printed circuit board comprising three substrates of electrically insulating material, and comprising two first windings and two second windings of the type described above.

More specifically, in Figure 3, the planar inductor is indicated 40; the printed circuit board is indicated 42; the substrates are indicated 44.1, 44.2, 44.3; the first windings are indicated 46.1, 46.2; the second windings are indicated 48.1, 48.2; the outer and inner ends of first windings 46.1, 46.2 are indicated 50.1, 50.2 and 52.1, 52.2 respectively; the outer and inner ends of second windings 48.1, 48.2 are indicated 54.1, 54.2 and 56.1, 56.2 respectively; the first, second, and third metalized through hole are indicated 58.1, 58.2 and 58.3 respectively; the axis of windings 46.1, 46.2, 48.1, 48.2 is indicated A; the axis along which the inner ends of windings 46.1, 46.2, 48.1, 48.2 are aligned is indicated B; the axis along which the outer ends of first planar windings 46.1, 46.2 are aligned is indicated C; and the axis along which the outer ends of second planar windings 48.1, 48.2 are aligned is indicated D.

Unlike Figure 2, in the Figure 3 planar inductor 40, each of the two second planar windings 48.1, 48.2 is not located on the face of relative substrate 44.1, 44.2, 44.3 opposite the face on which respective first planar winding 46.1, 46.2 is located; first planar windings 46.1, 46.2 are located on opposite faces of substrate 44.1; second planar windings 48.1, 48.2 are located on opposite faces of substrate 44.3; and substrate 44.2 separates first planar winding 46.2 and second planar winding 48.1.

Tests conducted by the Applicant, in fact, have shown that this type of configuration - in which first planar windings 46.1, 46.2 are located on opposite faces of the same substrate, and second planar windings 48.1, 48.2 on opposite faces of another substrate - has several advantages, in terms of flux linkage, with respect to the configuration in which second windings 48.1, 48.2 are located on the opposite faces of the substrates to respective first planar windings 46.1, 46.2, though the latter configuration may still be used in place of the one shown in Figure 3.

What is shown in Figure 3 may be extended to multilayer printed circuit boards comprising any number of substrates of electrically insulating material and any number of first and second windings.

In which case, the first windings will be located, successively in pairs, on opposite faces of respective substrates; the second windings will be located, successively in pairs, on opposite faces of respective substrates; and the inner ends of the windings will all be connected electrically by means of one metalized through hole, as will the outer ends of the first windings, and the outer ends of the second windings.

Given the above relative to planar inductors formed on single-layer and multilayer printed circuit boards, numerous other types of planar inductors may therefore be devised by simply varying the number of pairs of first and second windings and the way in which they are connected.

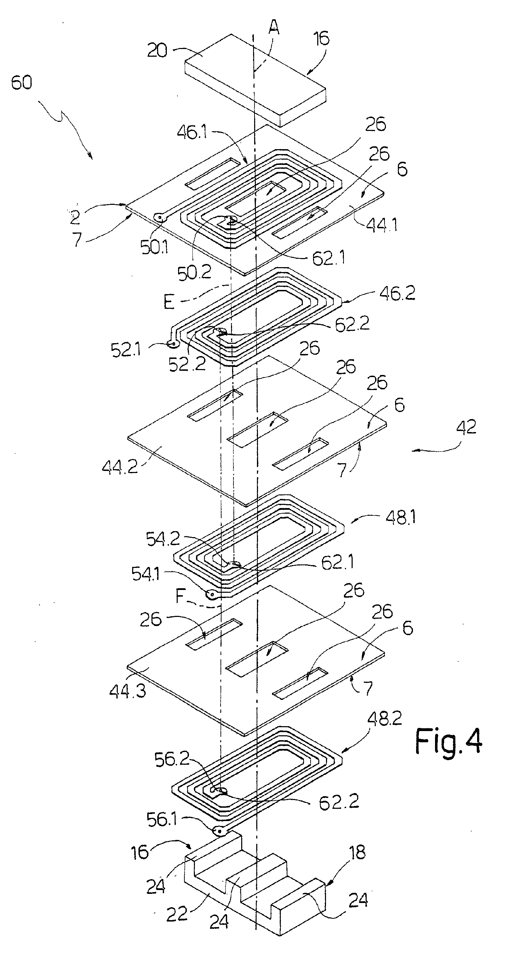

Figure 4, for example, shows a variation of the Figure 3 planar inductor, in which the two first planar windings 46.1, 46.2 and two second planar windings 48.1, 48.2 form a planar transformer 60. Any parts in Figure 4 identical with those in Figure 3 are therefore indicated using the same reference numbers.

As shown in Figure 4, to form transformer 60, the windings must be formed so that inner ends 50.2, 54.2 of first and second planar winding 46.1, 48.1 in the first pair are coaxial (axis E), and inner ends 52.2, 56.2 of first and second planar winding 46.2, 48.2 in the second pair are coaxial with each other (axis F) but offset with respect to those in the first pair, so that the two pairs of inner ends 50.2, 54.2 and 52.2, 56.2 can be electrically connected separately by means of respective metalized through holes 62.1, 62.2.

The first and second planar winding 46.1, 48.1 in the first pair therefore define a first continuous planar winding, whose terminals are defined by outer ends 50.1 and 54.1; while the first and second planar winding 46.1, 48.1 in the second pair define a second continuous planar winding, whose terminals are defined by outer ends 52.1 and 56.1.

Though distinct, the first and second continuous planar windings are connected to each other by planar core 16, and so actually define the primary and secondary windings of a planar transformer.

Another variation of Figure 4 could be to connect the two continuous planar windings in series to form a single continuous planar winding.

To do this, the windings should be formed so that the outer end 52.1 of first winding 46.2 in the second pair and the outer end 54.1 of second winding 48.1 in the first pair are coaxial and connectable electrically by means of a metalized through hole. This may be done by simply extending one or both outer ends of the two windings accordingly.

Clearly, changes may be made to what is described and illustrated herein without, however, departing from the scope of the present invention as defined in the accompanying Claims.

For example, planar core 16 may be other than as described, and in particular may be defined by two E-shaped members similar to first member 18 described.

The two members defining planar core 16 may be separated by a gap formed on one or more of projecting portions 24 of first member 18.

As opposed to a single metalized through hole, two or more ends of the windings may be connected electrically by means of two or more metalized through holes connected in parallel by tracks to increase current flow through the metalized through holes.

## Claims

1. A planar inductor (30; 40; 60), **characterized by** comprising at least one substrate (4; 44.1, 44.2, 44.3) of electrically insulating material; at least one first and one second planar winding (10, 32; 46.1, 46.2, 48.1, 48.2) located on opposite faces of said substrate (4; 44.1, 44.2, 44.3), and each having an outer end (12, 34; 50.1, 52.1, 54.1, 56.1) and an inner end (14, 36; 50.2, 52.2, 54.2, 56.2); a planar core (16), for said first and said second planar winding (10, 32; 46.1, 46.2, 48.1, 48.2), carried by said substrate (4; 44.1, 44.2, 44.3); and first connecting means (38; 58.1; 60.1, 60.2) for electrically connecting the inner ends (14; 50.2, 52.2, 54.2, 56.2) of said first and said second planar winding (10, 32; 46.1, 46.2, 48.1, 48.2) through said substrate (4; 44.1, 44.2, 44.3) to form a continuous planar winding, whose outer ends (12, 34; 50.1, 52.1, 54.1, 56.1) define terminals of said planar inductor.

2. A planar inductor as claimed in Claim 1, **characterized in that** said first and said second planar winding (10, 32; 46.1, 46.2, 48.1, 48.2) are coiled in the same winding direction when viewed from the same side of said substrate (4; 44.1, 44.2, 44.3)

3. A planar inductor as claimed in Claim 2, **characterized in that** said first planar winding (10; 46.1, 46.2) is coiled inwards, and said second planar winding (32; 48.1, 48.2) is coiled outwards.

4. A planar inductor as claimed in any one of the foregoing Claims, **characterized in that** said first and said second winding (10, 32; 46.1, 46.2, 48.1, 48.2) are coaxial with each other.

5. A planar inductor as claimed in any one of the foregoing Claims, **characterized in that** said first connecting means comprise at least one metalized through hole (38; 58.1; 60.1, 60.2).

6. A planar inductor as claimed in any one of the foregoing Claims, **characterized in that** said substrate (4; 44.1, 44.2, 44.3) comprises three through openings (26), one central in the center of said first and said second winding (10, 32; 46.1, 46.2, 48.1, 48.2), and two lateral on diametrically opposite sides of the first and second winding (10. 32; 46.1, 46.2, 48.1, 48.2); and **in that** said planar core (16) comprises a first and a second member (18, 20) sandwiched on opposite sides of said substrate (4; 44.1, 44.2, 44.3); said first member (18) being E-shaped and comprising a platelike base portion (22), and three projecting portions (24) projecting from said base portion (22) and inserted through said through openings (26); and said second member (20) being positioned facing said projecting portions (24) of said first member (18).

7. A planar inductor as claimed in any one of the foregoing Claims, **characterized by** comprising two said first planar windings (46.1, 46.2); two said second planar windings (48.1, 48.2); and three said substrates (44.1, 44.2, 44.3), each separating two said planar windings (46.1, 46.2, 48.1, 48.2).

8. A planar inductor as claimed in Claim 7, **characterized in that** said first planar windings (46.1, 46.2) are located on opposite faces of one of said substrates (44.1); and said second planar windings (48.1. 48.2) are located on opposite faces of another of said substrates (44.3).

9. A planar inductor as claimed in Claim 7, **characterized in that** one of said first planar windings (46.1, 46.2) and one of said second planar windings (48.1, 48.2) are located on opposite faces of one of said substrates (44.1, 44.3); and another of said first planar windings (46.1, 46.2) and another of said second planar windings (48.1, 48.2) are located on opposite faces of another of said substrates (44.1, 44.3).

10. A planar inductor as claimed in any one of Claims 7 to 9, **characterized by** comprising second connecting means (58.1) for electrically connecting the inner ends (50.2, 52.2, 54.2, 56.2) of said first and second planar windings (46.1, 46.2, 48.1, 48.2) through said substrates (44.1, 44.2, 44.3); third connecting means (58.2) for electrically connecting the outer ends (50.1, 52.1) of said first windings (46.1, 46.2) through said substrates (44.1, 44.2, 44.3); and fourth connecting means (58.3) for electrically connecting the outer ends (54.1, 56.1) of said second windings (48.1, 48.2) through said substrates (44.1, 44.2, 44.3).

11. A planar inductor as claimed in any one of Claims 7 to 9, **characterized by** comprising fifth connecting means (60.1) for electrically connecting the inner ends (50.2, 54.2) of a said first planar winding (46.1) and of a relative said second planar winding (48.1) through said substrates (44.1, 44.2, 44.3) to form a continuous planar winding; and sixth connecting means (60.2) for electrically connecting the inner ends (52.2, 56.2) of another said first planar winding (46.2) and of a relative said second planar winding (48.2) through said substrates (44.1, 44.2, 44.3) to form another continuous planar winding; said continuous planar windings being connected to each other by said planar core (16), and respectively defining a primary winding and a secondary winding of a planar transformer (60).

12. A planar inductor as claimed in Claim 10 or 11, **characterized in that** each of said connecting means comprises at least one respective metalized through hole (58.1, 58.2, 58.3; 60.1, 60.2).

13. A method of fabricating a planar inductor (30; 40; 60), **characterized by** comprising the steps of:
- forming, on opposite faces of a substrate (4; 44.1, 44.2, 44.3), a first and a second planar winding (10, 32; 46.1, 46.2, 48.1, 48.2), each having an outer end (12, 34; 50.1, 52.1, 54.1, 56.1) and an inner end (14, 36; 50.2, 52.2, 54.2, 56.2);
- electrically connecting the inner ends (14; 50.2, 52.2, 54.2, 56.2) of said first and said second planar winding (10, 32; 46.1, 46.2, 48.1, 48.2) through said substrate (4; 44.1, 44.2, 44.3) to form a continuous planar winding; the outer ends (12, 34; 50.1, 52.1, 54.1, 56.1) of said continuous planar winding defining terminals of said planar inductor; and
- connecting a planar core (16) to said first and said second planar winding (10, 32; 46.1, 46.2, 48.1, 48.2).

14. A fabrication method as claimed in Claim 13, **characterized in that** said first and said second winding (10, 32; 46.1, 46.2, 48.1, 48.2) are coiled in the same direction when viewed from the same side of said substrate (4; 44.1, 44.2, 44.3)

15. A fabrication method as claimed in Claim 14, **characterized in that** said first planar winding (10; 46.1, 46.2) is coiled inwards, and said second planar winding (32; 48.1, 48.2) is coiled outwards.

16. A fabrication method as claimed in any one of Claims 13 to 15, **characterized in that** said first and said second winding (10, 32; 46.1, 46.2, 48.1, 48.2) are coaxial with each other.

17. A fabrication method as claimed in any one of Claims 13 to 16, **characterized in that** said step of electrically connecting comprises the step of forming at least one metalized through hole (38; 58.1; 60.1, 60.2).

18. A fabrication method as claimed in any one of Claims 13 to 17, for a planar core (16) comprising a first and a second member (18, 20); said first member (18) being E-shaped and comprising a platelike base portion (22), and three projecting portions (24) projecting from said base portion (22); **characterized in that** said step of connecting said planar core (16) to said first and said second winding (10, 32; 46.1, 46.2, 48.1, 48.2) comprises the steps of:
- forming, on said substrate (4; 44.1, 44.2, 44.3), three through openings (26), one central in the center of said first and said second winding (10, 32; 46.1, 46.2, 48.1, 48.2), and two lateral on diametrically opposite sides of the first and second winding (10, 32; 46.1, 46.2, 48.1, 48.2);
- sandwiching said first and said second member (18, 20) of said planar core (16) to opposite faces of said substrate (4; 44.1, 44.2, 44.3), with the projecting portions (24) of the first member (18) inserted through said through openings (26), and with said second member (20) facing said projecting portions (24) of said first member (18).

19. A fabrication method as claimed in any one of Claims 13 to 18, **characterized by** also comprising the step of forming two said first planar windings (46.1, 46.2); two said second planar windings (48.1, 48.2); and three said substrates (44.1, 44.2, 44.3), each separating two said planar windings (46.1, 46.2, 48.1, 48.2).

20. A fabrication method as claimed in Claim 19, **characterized in that** said first planar windings (46.1, 46.2) are located on opposite faces of one of said substrates (44.1); and said second planar windings (48.1. 48.2) are located on opposite faces of another of said substrates (44.3).

21. A fabrication method as claimed in Claim 19, **characterized in that** one of said first planar windings (46.1, 46.2) and one of said second planar windings (48.1, 48.2) are located on opposite faces of one of said substrates (44.1, 44.3); and another of said first planar windings (46.1, 46.2) and another of said second planar windings (48.1, 48.2) are located on opposite faces of another of said substrates (44.1, 44.3).

22. A fabrication method as claimed in Claim 19 or 20, **characterized by** also comprising the steps of:
- connecting the inner ends (50.2, 52.2, 54.2, 56.2) of said first and second planar windings (46.1, 46.2, 48.1, 48.2) through said substrates (44.1, 44.2, 44.3);
- connecting the outer ends (50.1, 52.1) of said first windings (46.1, 46.2) through said substrates (44.1, 44.2, 44.3); and
- connecting the outer ends (54.1, 56.1) of said second windings (48.1, 48.2) through said substrates (44.1, 44.2, 44.3).

23. A fabrication method as claimed in Claim 19 or 20, **characterized by** also comprising the steps of:
- electrically connecting the inner ends (50.2, 54.2) of a said first planar winding (46.1) and of a relative said second planar winding (48.1) through said substrates (44.1, 44.2, 44.3) to form a continuous planar winding;
- electrically connecting the inner ends (52.2, 56.2) of another said first planar winding (46.2) and of a relative said second planar winding (48.2) through said substrates (44.1, 44.2, 44.3) to form another continuous planar winding;
said continuous planar windings being connected to each other by said planar core (16), and respectively defining a primary winding and a secondary winding of a planar transformer (60).

24. A fabrication method as claimed in Claim 22 or 23, **characterized in that** each of said steps of electrically connecting comprises the step of forming at least one metalized through hole (58.1, 58.2, 58.3; 60.1, 60.2).
